(19) Europäisches Patentamt
European Patent Office
Office européen des brevets

(11) **EP 2 120 058 A2**

(12) **EUROPEAN PATENT APPLICATION**

(43) Date of publication:
**18.11.2009 Bulletin 2009/47**

(51) Int Cl.:
***G01R 31/08*** *(2006.01)*

(21) Application number: **09159922.5**

(22) Date of filing: **11.05.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **14.05.2008 US 53213 P**

(71) Applicant: **Acterna, LLC**
**Germantown, MD 20876 (US)**

(72) Inventor: **Ng, Anthony C.**
**Calabasas CA California 91302 (US)**

(74) Representative: **Walker, Stephen**
**Murgitroyd & Company**
**Scotland House**
**165-169 Scotland Street**
**Glasgow G5 8PL (GB)**

(54) **Locating a low-resistance fault in an electrical cable**

(57) An inductance-based cable length-to-fault measurement device and method are described. The cable under test having a per-unit-length inductance is coupled to an inductance-sensitive oscillator, and the frequency of oscillations is evaluated using the following serially coupled modules: a comparator for digitizing the oscillator output, a pre-scaler for oscillation frequency down-conversion, and a microprocessor for counting pulses from the pre-scaler. To remove environmental and manufacturing tolerance dependencies, as well as a battery voltage dependence, the measured frequency of oscillations is compared to a frequency of oscillations of the oscillator having coupled thereto a reference inductor.

FIG. 1

EP 2 120 058 A2

Description

## CROSS-REFERENCE TO RELATED APPLICATIONS

The present invention claims priority from United States Patent Application No. 61/053,213 filed May 14, 2008, entitled "Determining Distance-To-Short Of A Coax, Data Or Communication Cable", by Ng, which is incorporated herein by reference for all purposes.

## TECHNICAL FIELD

The present invention is related to testing electrical cables, and in particular to a device and a method for determining a cable length to a low-resistance fault in the cable.

## BACKGROUND OF THE INVENTION

An electrical cable is an insulated conductor or conductors used for transmitting electricity or communicating information. There are many types of electrical cables. A coaxial cable, a twisted-pair cable, a multi-wire cable, and a ribbon cable are examples of types of cables. It is quite common for cables to be run in difficult-to-reach areas, such as underground, underwater, under the floor or inside the walls of a house, or inside equipment that is difficult to take apart and then reassemble, such as an aircraft, for instance.

An electrical cable fault is a localized abrupt variation in a wire conductance or a wire-to-wire resistance that disrupts a normal performance of the cable. A loss of wire conductance due to a cable break, or a low-resistance cable fault due to a localized drop in a wire-to-wire or a wire-to-ground resistance are some of the examples of an electrical cable fault. Due to the mentioned limited accessibility of a cable, it is rather difficult, if not impossible in some cases, to determine the location of a fault by directly observing the cable. A number of indirect methods have therefore been developed to determine the location of a cable fault.

One of such methods consist of applying a radio frequency electrical signal at an accessible point of a cable under test and carrying, along the length of the cable, a radio wave detector tuned to that particular radio frequency, to detect a signal emitted at a fault point of the cable. The drawback of this method is that, in a frequent case of an underground or an over-the-air telegraph pole cable, a fault can be located quite far from the accessible end of the cable, so that a field test technician walking or driving along the cable and carrying with him the radio wave detector, has to travel sometimes for many thousands of feet before a location of the fault can be determined.

A more advanced method of locating a cable fault consists of sending out an electrical pulse in the cable under test, from an accessible point of the cable towards a fault, and measuring the time interval between sending the pulse and detecting a pulse reflected from the fault. By dividing the speed of propagation of the pulse in the cable by one half of the measured time interval between sending and receiving the pulses, the cable length-to-fault can be evaluated. This method, called time-domain reflectometry (TDR), allows one to locate the fault more easily than the radio wave detection method mentioned above since no carrying of a detector along the cable is necessary; however, the TDR method, as well as a related method of frequency-domain reflectometry, requires complicated test equipment and specialized training of personnel servicing the test equipment.

An alternative method of evaluating a length-to-fault in an electrical cable or a wire consists in measuring the in-phase and in-quadrature components of a low-frequency electrical impedance spectrum and deducing, from the variety of spectra obtained, the magnitude of the resistance and the length to the cable fault. Such a method is described in US Patent 7,076,374 issued in the name of Rogovin, assigned to the Boeing Company, and incorporated herein by reference. A drawback of the method ofRogovin is the complexity of the data collection apparatus, as the complexity of the data processing and the data interpretation.

Yet another method of evaluating a length-to-fault in an electrical cable consists in evaluating an electric capacitance of the cable and dividing the value of the capacitance by a per-unit-length capacitance of a particular type of the cable under test. US Patent 6,646,454 issued in the name of Watkins, assigned to Test-Um, Inc., and incorporated herein by reference, describes a capacitance-sensitive oscillator, the period of oscillations of which depends on a value of the electrical capacitance of a cable connected to the oscillator.

The method of Watkins has the advantage of allowing a rather quick measurement with a relatively simple test circuit. However, the method of Watkins has some limitations. For example, using the capacitance method of Watkins, one cannot measure the distance to a low-resistance cable fault. The Test-Um capacitance method allows one to measure distance to a cable break that behaves like an electrical open. Yet, low-resistance faults commonly happen when, for example, a carpet installer inadvertently drives a carpet nail into a TV cable, phone line, or a network data cable, and causes, albeit not a perfect short, but a low-resistance fault in that cable. Distance to a low-resistance cable fault could not be measured by using the Watkins capacitance method.

Furthermore, we believe that the method of Watkins cannot be used to accurately measure a cable length between two end points in a cable network configured as a star network. A star network is one that has multiple cables connected at a common node, such as in a TV cable network. Since the capacitance method measures all capacitance cables in the star network, it provides the total length of all cables in a star network instead of that of only the faulty segment.

It is the goal of the present invention to provide a simple, inexpensive, and robust apparatus for measurement of a length to a low-resistance cable fault, including a selective measurement of the cable length from the measurement point to a low-resistance fault in one of the branches of a star network. This selection should occur automatically, without having to identify the faulted cable branch before the measurement takes place.

The present invention achieves the stated goal by providing a novel apparatus and method for cable length-to-fault measurement. As an option, the present invention allows one to measure a cable length to a short stub, which is provided as an accessory with the product, that shorts out the opposite end of the target cable segment in the star network. Advantageously, an apparatus of the present invention is simple, inexpensive, compact, and does not require extensive training of the service personnel using it.

## SUMMARY OF THE INVENTION

In accordance with the invention there is provided a device for measuring a length $l_{fault}$ between a measurement point of a test cable having an inductance, and a low-resistance fault point of the test cable, wherein the device comprises an oscillator having an input and an output, for producing, at its output, electrical oscillations characterized by an oscillation period depending upon the inductance of the test cable coupled to the input of the oscillator at the measurement point, wherein said inductance is representative of the length $l_{fault}$; and a microprocessor for determining the length $l_{fault}$ by measuring a test value based on said oscillation period and comparing the measured test value to a reference value.

In accordance with another aspect of the invention there is further provided a method for measuring a length $l_{fault}$ between a measurement point of a test cable having an inductance, and a low-resistance fault point of said test cable, wherein the method comprises:

(a) coupling the test cable to an input of an oscillator circuit at the measurement point, wherein the oscillator circuit is characterized by an oscillation period, and wherein, upon said coupling, said oscillation period is dependent upon the inductance of the test cable;

(b) measuring a test value based on the oscillation period of the oscillator; and

(c) determining the length $l_{fault}$ by comparing the measured test value to a reference value.

## BRIEF DESCRIPTION OF THE DRAWINGS

Exemplary embodiments will now be described in conjunction with the drawings in which:

FIG. 1 is a block diagram of a device for measuring a length to a low-resistance cable fault according to the present invention;

FIG. 2 is an equivalent circuit of an electrical cable having a low-resistance fault;

FIG. 3 is a circuit diagram of an inductive oscillator according to the present invention;

FIG. 4 is a circuit diagram of an input circuitry of a device for measuring a length to a low-resistance cable fault;

FIG. 5 is a circuit diagram of the comparator and pre-scaler according to the present invention;

FIG. 6 is a waveform at the output of the oscillator and comparator circuits;

FIG. 7 is a waveform at the output of the comparator and 1/4 pre-scaler circuits;

FIG. 8 is a waveform at the output of the comparator and 1/32 pre-scaler circuits;

FIG. 9 is a plot of inductance vs. cable length for a CAT5 cable; and

FIG. 10 is a plot of measured oscillator period vs. cable length.

## DETAILED DESCRIPTION OF THE INVENTION

While the present teachings are described in conjunction with various embodiments and examples, it is not intended that the present teachings be limited to such embodiments. On the contrary, the present teachings encompass various alternatives, modifications and equivalents, as will be appreciated by those of skill in the art.

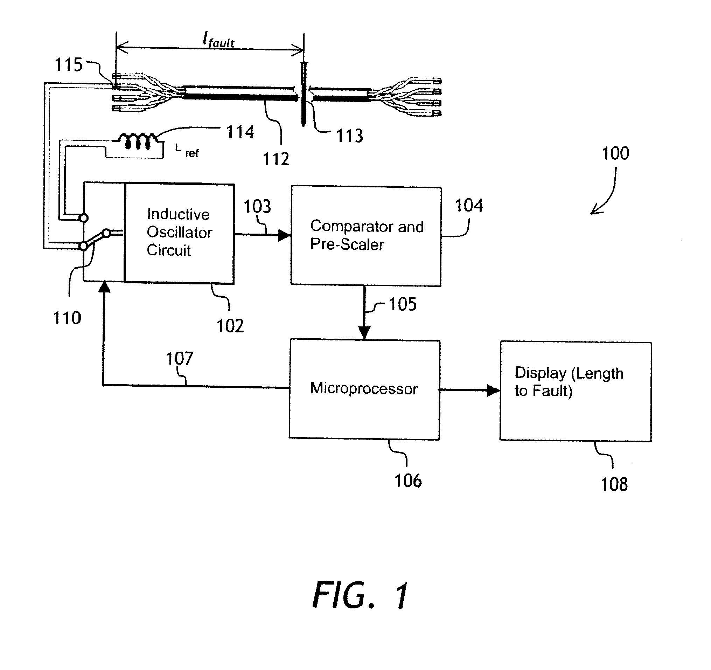

Referring to FIG. 1, a block diagram of an inductance based length-to-a-fault meter 100 of the present invention is shown comprising an inductive oscillator circuit 102, a comparator and pre-scaler circuit 104, a microprocessor 106, and a display 108. A switch 110 is used to switch an input of the oscillator 102 between: (a) an inductive faulted cable under test, or test cable 112 having a local low-resistance fault 113 symbolically shown as a nail driven through the cable 112; and (b) a reference inductor 114 having a reference inductance value of $L_{ref}$. The fault 113 is located at a distance $l_{fault}$ from a measurement point 115. Herein the term "low resistance" means a resistance that is significantly lower than a nominal resistance between wires in the cable 112, such that a normal performance of the cable 112 is disrupted. For example, for a case when the cable 112 is a television coaxial or a Category 5 (CAT5) twisted-pair data cable, the value of the resistance of the low-resistance fault 113 can be from 0Ω to about 100Ω.

Links 103, 105, and 107 are wires or conductors carrying a corresponding electrical signal. The input and the output of the oscillator 102, the input and the output of the comparator and the pre-scaler 104, and the input of the counting register of the microprocessor 106 are electrical terminals electrically coupled to corresponding wires or conductors.

The operation of the meter 100 will now be explained. The inductive oscillator circuit 102 produces oscillations at its output, wherein the period of oscillations and, therefore, the frequency of oscillations depend on an inductance of a circuit coupled to its input. At the position of the switch 110 shown in FIG. 1, the input of the oscillator 102 is coupled to the faulted cable 112 at the point 115, wherein the cable inductance is representative of the distance $l_{fault}$ from the measurement point 115 to the fault point 113. The oscillator circuit 102 is constructed in such a way that the effect of a series resistance of the cable 112 on the oscillation period or frequency is largely attenuated by the gain of the oscillator circuit 102. More detail on construction of the circuit 102 and the effect of capacitance and resistance on the oscillation period or frequency will be provided below. The comparator and pre-scaler circuit 104 of FIG. 1, coupled to the output of the oscillator circuit 102 through the link 103, is used to provide a digital signal at the output of the circuit 104, wherein said digital signal is characterized by a period of oscillations that is a multiple of a period of oscillations of the oscillator 102. In other words, said digital signal is characterized by a frequency that is a fraction of a frequency of oscillations of the oscillator circuit 102. The circuit 104 and its operation will be also described in more detail below. The microprocessor 106 of FIG. 1, coupled to the output of the comparator and pre-scaler circuit 104 through the link 105, measures the frequency of oscillations of the digital signal at the output of the circuit 104, by counting the digital signal pulses during a pre-determined measurement time window called herein a gating time window. The frequency of oscillations at the output of the circuit 104 is a fraction of a frequency of oscillations of the oscillator which, through the dependence of its frequency of oscillations on the inductance of the cable 112, and the dependence of the inductance of the cable 112 on the length-to-fault $l_{fault}$, is dependent on $l_{fault}$. After performing the above-described frequency measurement, the microprocessor 106, through the link 107, switches the switch 110 to the upper position in FIG. 1 and proceeds to measure a frequency of oscillations representative of the reference inductance value $L_{ref}$ of the reference inductor 114. The value of $l_{fault}$ is then calculated by taking a ratio of these two measured frequencies.

It should be understood that any test value based on the oscillation period of the oscillator, such as frequency, a pulse duration time, a voltage at the output of a frequency-to-voltage converter, etc., can be used as a value to be measured according to a method of the present invention. A ratio of the test values obtained with a test cable and a reference inductor alternately connected to the input of an oscillator can be used to calculate the value of $l_{fault}$. In a more general aspect of the invention, the test values have to be compared to each other in some way to obtain the value of $l_{fault}$. For example, a difference of the test values should be used if the test values are proportional to a logarithm of the oscillation period. Further, any processing device, such as a central processing unit (CPU) of a microcomputer, can be used instead of the microprocessor 106, to perform necessary calculations.

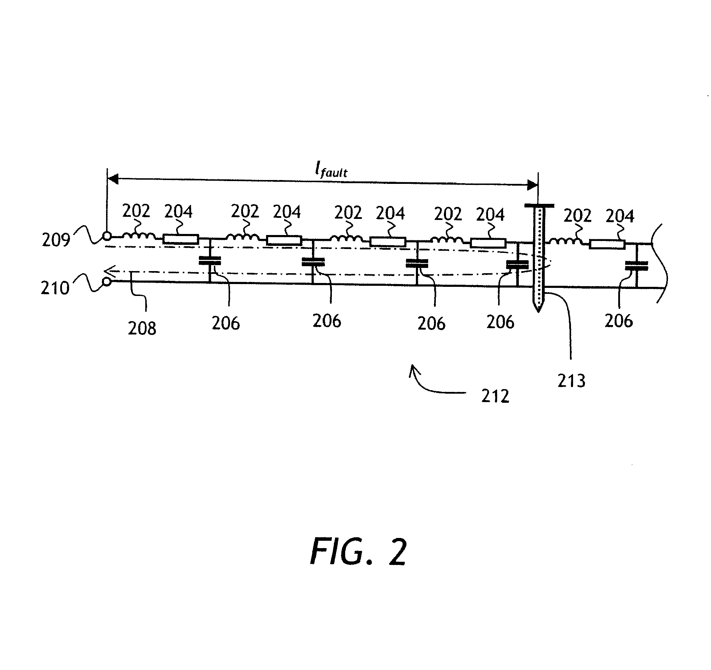

Turning now to FIG. 2, an equivalent circuit of an electrical cable 212 having a low-resistance fault 213 is shown comprising a distributed inductance 202, a distributed resistance 204, and a distributed capacitance 206. The low-resistance fault 213 short-circuits the capacitors 206 and closes a conductive-inductive loop 208 between terminals 209 and 210. The inductance or resistance of the cable 212 to the right side of the fault 213 is irrelevant since it is outside of the loop 208. As a result, the inductance of the loop 208 is proportional to the length of the cable 212 to the fault $l_{fault}$. This is a very important feature of the present invention, since it makes the measurement virtually insensitive to presence of any other cable, including a non-damaged cable star-coupled to the damaged cable 212 at a location to the left from the fault 213 in FIG. 2. The star-coupled cable is not shown in FIG. 2.

The resistance of the loop 208 is not proportional to $l_{fault}$ since said resistance also depends of a value of the resistance of the fault 213 which, in general, is unknown and not negligible as compared to a value of the resistance of the cable 212. Since the resistance of the fault 213 is unknown, the oscillator 102 of FIG. 1 is constructed so as to attenuate the impact of a series resistance coupled to its input.

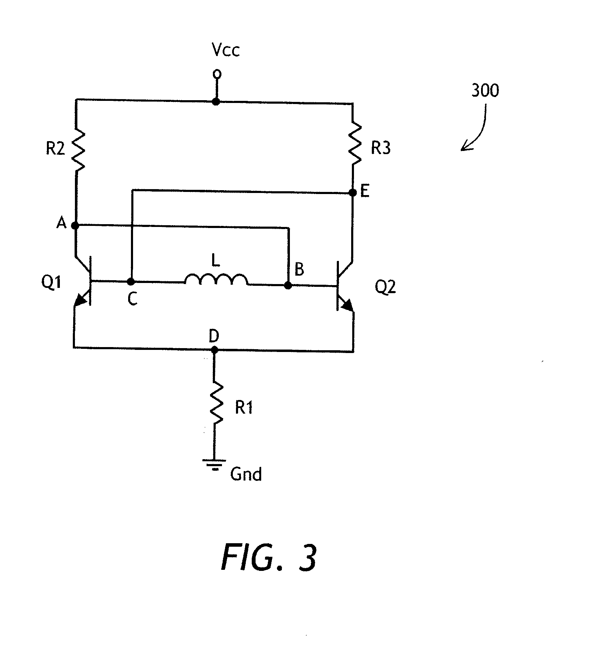

The construction of an exemplary embodiment of an oscillator according to the present invention will now be described. Referring to FIG. 3, an oscillation circuit 300 contains two radio-frequency n-p-n transistors Q1 and Q2 connected in common-emitter configuration having a common emitter resistor R1. The transistors Q1 and Q2 have resistive collector loads R2 and R3, respectively. Positive feedback, or a.c. regeneration, is achieved via phase inversion created by connecting the collector of one transistor to the base of the other transistor in the presence of an inductor L having an inductance $L$. Regeneration at d.c. is not possible once the inductance $L$ and an electrical current gain β of the two transistors Q1 and Q2 exceed certain values, which results in an oscillation at start-up. Component mismatches or a circuit perturbation develops a positive feedback in one side of the circuit. The transistors Q1 and Q2 have a sufficiently high gain-bandwidth product, e.g. 1.4GHz or higher, to not affect the oscillation period.

Once one transistor is open and the other is closed, the resulting current flowing through the inductor creates a voltage proportional to $L di/dt$. By assuming, for certainty, that the transistor Q1 is open and the transistor Q2 is closed, and by considering a voltage drop between a point Vcc and a point Gnd in going through points A, B, C, and D in FIG. 3, by considering the following paths of the electric current: Vcc-A-B-C-D-Gnd, Vcc-A-D-Gnd, and Vcc-E-C-D-Gnd, one can write the following equation:

$$\text{Vcc} = i_c(t)(1 + 1/\beta)(R_1 + R_2) + V_{be}(t) - (L/\beta)\mathrm{d}i_c(t)/\mathrm{d}t + i_c(t)(R_L/\beta) =$$

$$= i_c(t)[(1 + 1/\beta\ (R_1 + R_2) + (R_L/\beta)] + V_{be}(t) - (L/\beta)\mathrm{d}i_c(t)/\mathrm{d}t \approx$$

$$\approx i_c(t)(\ R_1 + R_2 + R_L/\beta\ ) + V_{be}(t) - (L/\beta)\mathrm{d}i_c(t)/\mathrm{d}t \qquad (1)$$

wherein $i_c(t)$ is a time-dependent current through the inductor L having the inductance $L$ and a resistance $R_L$, $V_{be}(t)$ is a time-dependent emitter-base voltage of the open transistor Q1, and $R_1$, $R_2$, and $R_3$ are the values of resistance of the resistors R1, R2, and R3, respectively.

By solving the Eq. 1, it can be shown that a time constant $TC$ of oscillations of the oscillator represented in FIG. 3 is equal to:

$$TC = L/(R_2 + R_3 + R_L/\beta) \qquad (2)$$

Preferably, the parameters of the elements shown in FIG. 3 are chosen such that the oscillator is not saturated, so the storage time and the period of oscillations of the oscillator is minimized.

In the meter of the present invention, the cable being measured is connected to the base pins C and B of two transistors Q1 and Q2, respectively, that form a very simple oscillator, which enables the influence of the cable and the fault resistance on the oscillation period to be greatly attenuated by the gain β of the transistors Q1 and Q2. As is seen from Eq. (2), the oscillation time constant $TC$ depending largely on the cable inductance $L$ and the sum resistance $R_2 + R_3$ of the resistors R2 and R3. This key advantage allows the device of the present invention to determine cable length to both completely shorted faults and not completely shorted faults, with residual resistance of as much as 70Ω still allowing the measurement to be performed. The oscillator 300 may still be somewhat sensitive to capacitance and resistance of an input circuit coupled to the oscillator between the terminals B and C. Yet the sensitivity of the oscillation period to a relative variation of inductance is much higher than the sensitivity to a relative variation of resistance or capacitance. Herein, the term "relative variation" is understood as a per cent variation, that is, an absolute variation of a parameter divided by its original value.

The oscillator of the present invention, the circuit of which is shown in FIG. 3, has a number of important advantages over an oscillator taught by Watkins in US Patent 6,646,454. The LMC555 timer-based oscillator described by Watkins is not fast enough if it were adapted to sense a small inductance of the cable. The fastest 555 timer in the market has a propagation delay of 200 nanoseconds, or 200 billionths of a second. This is just the propagation delay, without delays from the rest of the oscillator circuit and the cable under test taken into account. To measure a distance to a low-resistance fault in a cable with a few feet of resolution for down to less than 10 feet of cable length using the cable's inductance, the oscillator circuit needs to oscillate with a period as short as 60 nanoseconds. The overall measurement circuit needs to resolve difference in oscillation period of as short as 5 to 10 nanoseconds. This is why, after a number of failed experiments, an oscillator circuit based on radio frequency bipolar transistors with 1.4GHz gain-bandwidth product was selected for this application. The simplicity of the oscillation circuit of the present invention, in comparison with the 555 timer circuit, provides sufficiently high oscillation frequency that allows the cable's small inductance of as little as 10uH, that is 10 micro Henry, to be resolved. The circuit imposes no upper limit on a measurable cable length as long as the capacitance and series resistance of the cable are sufficiently low. A number of inductor-based oscillator circuits can be used for this application.

In general, the oscillator of FIG. 3 has three important advantages over inductance oscillation circuits employing a wide-band amplifier: a cost-effectiveness advantage, since only a few components are required; an advantage of the influence of the series resistance of the cable and the resistance of the fault on the oscillation period being largely attenuated by the circuit gain; and the advantage of having the oscillation period proportional to the inductance of the test cable, allowing the length-to-fault $l_{fault}$ to be easily determined based on an oscillation parameter measured relative to a reference inductor sample.

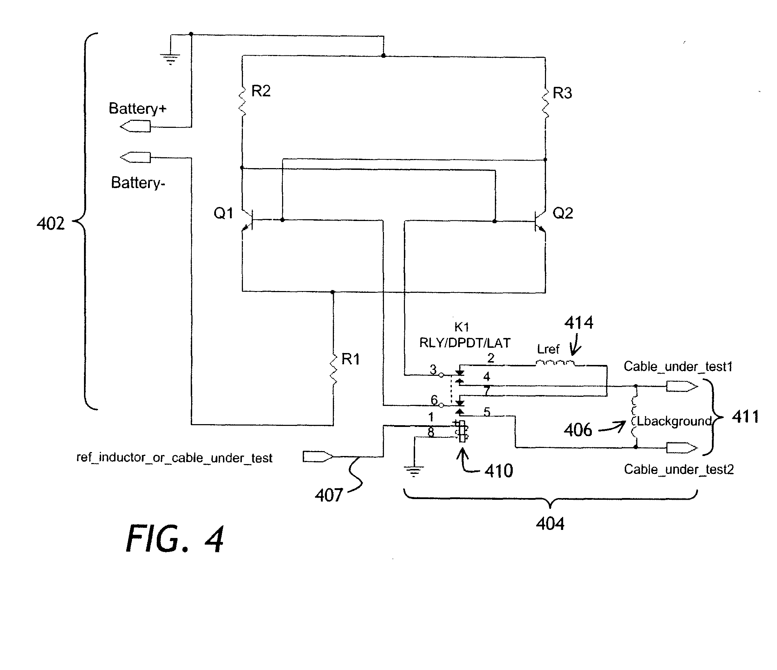

Turning now to FIG. 4, a circuit diagram of an input circuitry of the length-to-fault meter of the present invention is shown having an oscillator circuit 402 and an input switching circuit 404 comprising an input switch relay 410, a reference inductor 414 having an inductance $L_{ref}$, a background inductor 406 having an inductance $L_{background}$, and terminals 411 for connecting a test cable, not shown. A link 407, corresponding to the link 107 of FIG. 1, is used to energize the relay 410 of FIG. 4 and switch the input of the oscillator 402 from the reference inductor 414 to the terminals 411 coupled to the background inductor 406. The latter is used to ensure that the oscillator 402 can oscillate even when a cable under test (a test cable) is not connected to the terminals 411. The reference inductor 414 is a relatively small inductor, e.g. less than 400uH. For example, the reference inductor can have an inductance of 26uH, representing a 100 feet long twisted pair category 5 (CAT5) cable. The inductance $L_{background}$ is preferably less than 80uH. Other values could also be used for another target length-to-fault measurement range. The input switch relay 410 is preferably an electromechanical relay or an analog multiplexor.

The reference inductor 414 eliminates systematic errors via the circuit arrangement wherein both the reference inductor 414 and the test cable, not shown, share the same oscillator circuit and power supply. Due to the fact that the oscillator circuit is shared, manufacturing process variations of $Vcc$, of the gain β of the transistors Q1 and Q2, variations of $R_1$ and $R_2$, as well as temperature and aging induced fluctuations of said parameters, affect equally the oscillation periods measured using the reference inductor 414 and using the test cable. By applying Eq. (2) to the case of connected reference inductor 414 and to the case of connected test cable, one can write

$$TC_{ref} = L_{ref}/(R2 + R3 + R_{ref}/\beta) \qquad (3)$$

$$TC_{cable} = L_{cable}/(R2 + R3 + R_{cable}/\beta) \qquad (4)$$

where $TC_{ref}$ and $TC_{cable}$ are corresponding oscillation time constants.

Therefore,

$$TC_{cable} / TC_{ref} = L_{cable} / L_{ref} \qquad (5)$$

at a condition that the gain β is high enough so that $R_{ref}/\beta \ll (R_2 + R_3)$ and $R_{cable}/\beta \ll (R_2 + R_3)$. For $R_{ref}$ of 0.1Ω and β of 100, $R_{ref}/\beta$ is in the neighborhood of 0.001Ω, which is much smaller than $(R_2 + R_3)$ having a value of 120Ω in a manufactured prototype of the tester. For $R_{cable}$ of 70Ω, including the resistance of the fault itself, and β of 100, $R_{ref}/\beta$ is in the neighborhood of 0.7Ω, which is still much smaller than the 120Ω value.

Eq. (5) allows one to determine $L_{cable}$ and, therefore, the cable length-to-fault once the inductance of a unit length of the test cable is known, by comparing oscillation periods with the test cable and the reference 414 alternately coupled to an input of the oscillator 402. This determination is independent on oscillation period variations caused by supply voltage and component parameter variations, since these variations influence both measurements to an equal extent. The insensitivity to the supply voltage variations is especially important since a field test device is likely to be battery powered.

The cable length to a low-resistance fault of the cable under test can be calculated simply by multiplying an "equivalent cable length" corresponding to the inductance $L_{ref}$ of the reference inductor 414 by the ratio of the oscillation count measured within the abovementioned gating time window of the microprocessor when the cable under test is coupled to the oscillator 402, to the oscillation count measured within the gating time window of the same duration, when the reference inductor 414 is coupled to the oscillator 402. Of course, the duration of the gating time window may be adjusted between the measurements of test cable and of the reference, with an appropriate adjustment of the ratio of measured counts.

The number indicative of the inductance per unit length of a cable can be used to calculate the equivalent cable length mentioned in the previous paragraph. This equivalent cable length can be made user-adjustable, such that a user can adjust this number for testing different cables manufactured by different manufacturers. This adjustable number is needed because different models of cables may have different values of inductance per unit length. Once the user adjusts this number for a known length of a particular type of cable, the user could then use the tester to measure unknown distance to a low-resistance fault of the same type of cable, $l_{fault}$, according to the following equation:

$$l_{fault} = \frac{T_{cable}}{T_{reference}} \cdot \frac{\eta_{reference}}{\gamma_{cable}} \qquad (6)$$

wherein $T_{cable}$ and $T_{reference}$ are the oscillation periods of the oscillator having coupled to the input thereof the test cable and the reference inductor, respectively; $\eta_{reference}$ is an inductance value of the reference inductor; and $\gamma_{cable}$ is a per-unit-length inductance of the test cable.

Furthermore, the reference inductor 414 may be physically a length of a cable of the same type as the cable under test, the length being known to the user; this so called reference cable can be located outside of the tester of the present invention, being connectable through a pair of additional terminals, not shown, similar to the pair of terminals 411. In this latter case, the length $l_{fault}$ is determined as:

$$l_{fault} = \frac{T_{cable}}{T_{reference}} \cdot l_{reference} \qquad (7)$$

wherein $l_{reference}$ is the length of the reference cable.

It should be noted that the actual periods of oscillation $T_{cable}$ and $T_{reference}$ need not necessarily be determined during the measurement process. They are used in Eqs. (6) and (7) to highlight the fact that the length to fault $l_{fault}$ is proportional to a value representing the ratio of $T_{cable}$ and $T_{reference}$. As has been described above, the microprocessor counts pulses from the pre-scaler 506 within its gating window, with the reference inductor and the cable under test alternately coupled to the input of the oscillator, and then compares the counts to each other, by taking a ratio of the counts. Thus, the number of counts occurred within the gating window is all that needs to be measured.

The linear model described by Eqs. (5) to (7) above, in which the length to fault $l_{fault}$ is proportional to a measured value such as the oscillation period, provides sufficient measurement accuracy for day-to-day cable measurements. If a higher measurement accuracy is desired, a higher order polynomial model, such as a quadratic model, should be used. In the higher-order polynomial model, multiple coefficients are selected to account for second or third order non-linearity effect. The polynomial model can be expressed as

$$l_{fault} = a_0 + \sum_{n=1}^{N} a_n v^n \qquad (8)$$

wherein $v$ is the value measured, $a_0$, $a_n$ are coefficients, and $N$ is an integer number.

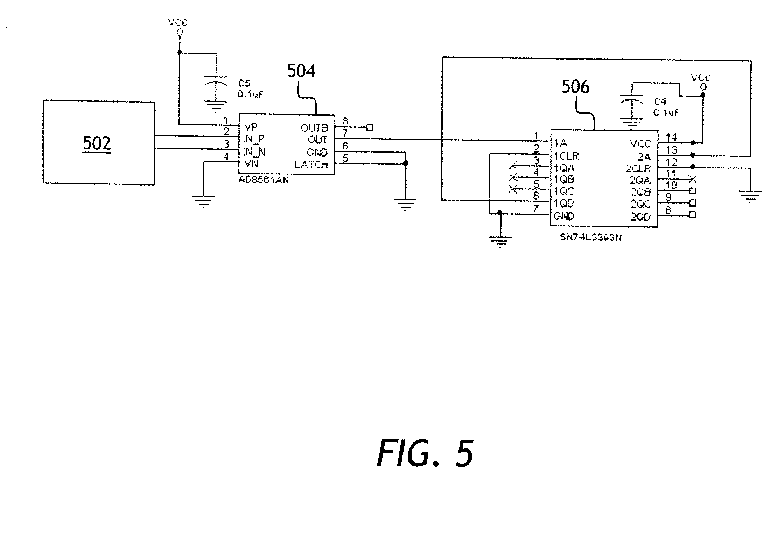

Turning now to FIG. 5, an implementation example of a comparator / pre-scaler 104 of FIG. 1 is presented. A circuit diagram of FIG. 5 shows an oscillator 502, a comparator module 504, and a pre-scaler module 506. The comparator 502 is, for example, a high-speed comparator AD8561AN manufactured by Analog Devices located in Norwood, Massachusetts, USA. Its function is to remove noise from the oscillation signal of the oscillator by converting the input analog waveform into a clean digital waveform of ones and zeroes.

The pre-scaler module 506 performs down-counting of the number of pulses produced at the output of the comparator 504, yielding a signal having a period of oscillation being equal to a multiple of periods of the input signal. The function of the pre-scaler module 506 is twofold. Firstly, it sums up many periods of the output comparator signal and, therefore, it sums up periods of oscillation of the oscillator 502, effectively performing an averaging function of the oscillation period of the oscillator 502. Secondly, it produces a signal having a low enough frequency to be measurable by a microprocessor, not shown. The microprocessor's counter registers have a limited number of bytes, and they may not be capable of accumulating counts generated from the shortest cable, producing the highest count, without a pre-scaler reducing those counts. The microprocessor, not shown, is capable of selecting different numbers of periods of oscillation for the pre-scaler 506 to sum up, for example it can select 32, 64, 128, 256 periods, and so on, effectively broadening the dynamic range of the measurement of the period or frequency of oscillations of the oscillator 502, and therefore, broadening the range of measurable cable lengths. The down-conversion is performed by the module 506 such that the microprocessor can handle the range of oscillation counts it needs to accumulate for both the shortest and the longest cable that the tester is constructed to measure.

It must be noted that the methodology of the present invention is not tied up to a particular range of frequencies. For the prototype built, the oscillation frequency before the prescaler ranges from 1.52MHz for no cable, wherein said frequency is set by a background inductor, to 200kHz for a 1000 feet long cable coupled to the oscillator input.

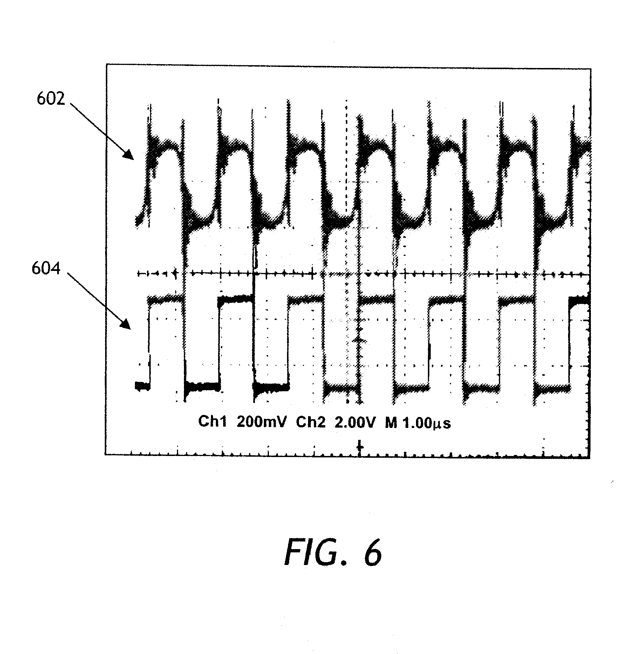

The function of the comparator 504 and the pre-scaler 506 of FIG. 5 will now be illustrated by means of experimentally recorded electrical waveforms. Referring to FIG. 6, a waveform 602 at the output of the oscillator circuit 502 of FIG. 5 and a waveform 604 of FIG. 6 at the output of the comparator circuit 504 of FIG. 5 is shown. The voltage scales for the signals 602 and 604 of FIG. 6 are 200mV and 2V per division, respectively. The time scale is 1μs per division. The signal 604 has much less noise and is higher in amplitude than the signal 602.

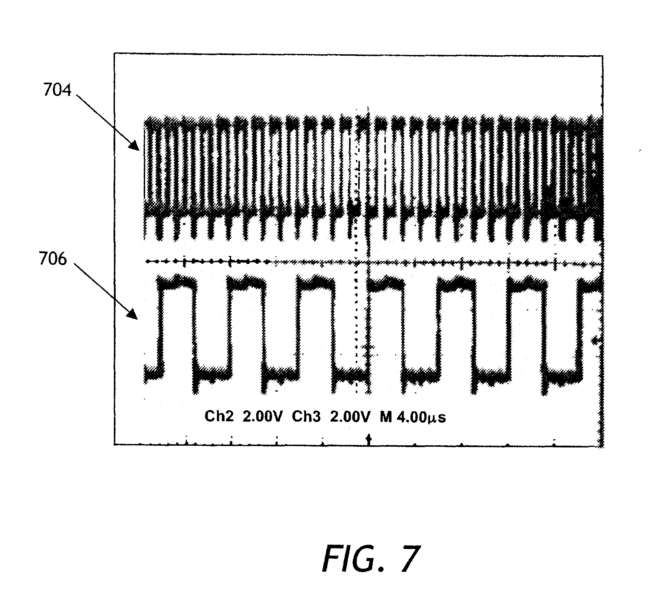

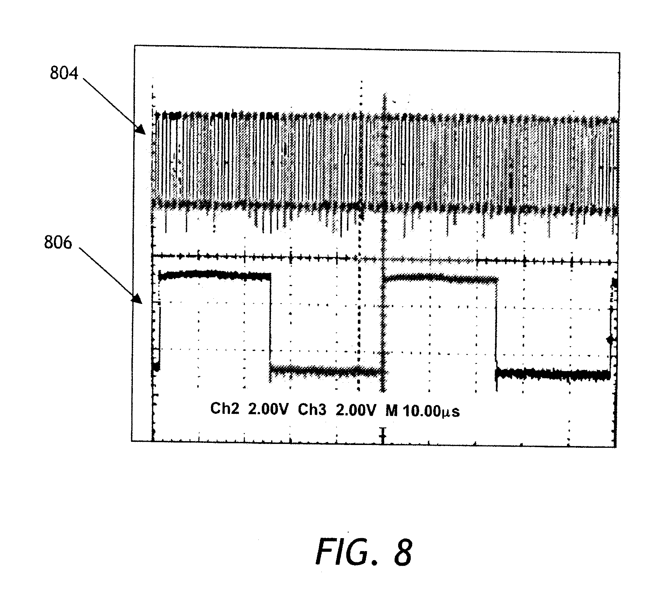

The function of the pre-scaler 506 of FIG. 5 is illustrated in FIGS. 7 and 8.
Referring now to FIG. 7, a waveform 704 at the output of the comparator circuit 504 of FIG. 5 and a waveform 706 of FIG. 7 at the output of the pre-scaler circuit 506 of FIG. 5 is shown. The voltage scale for the signals 704 and 706 of FIG. 7 is 2V per division. The time scale is 4μs per division. The frequency of the signal 706 is down-counted by a factor of four from the frequency of the signal 704. Turning now to FIG. 8, a waveform 804 at the output of the comparator circuit 504 of FIG. 5 and a waveform 806 of FIG. 8 at the output of the pre-scaler circuit 506 of FIG. 5 is shown. The voltage scale for the signals 804 and 806 of FIG. 8 is 2V per division. The time scale is 10μs per division. The frequency of the signal 806 is down-counted by a factor of thirty-two from the frequency of the signal 804.

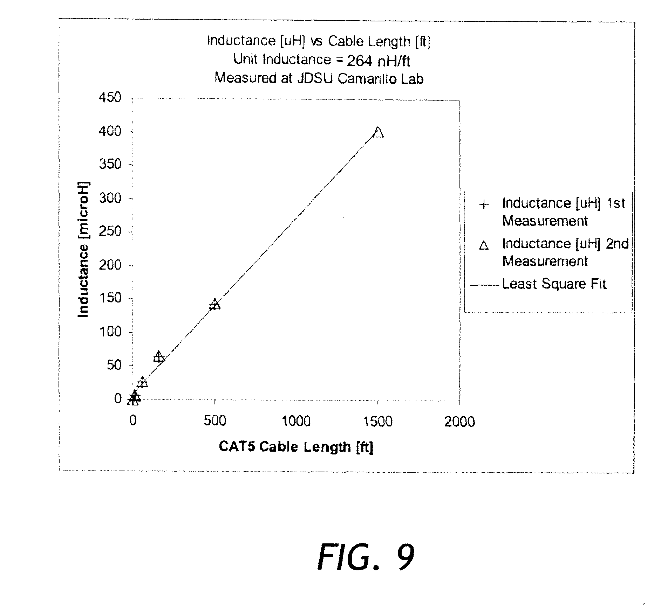

Inductance of CAT5 cables up to the length of 1500 feet was measured at a laboratory of JDS Uniphase Corporation, located at Camarillo, California, USA. The inductance was measured using a LCR meter model 875A from B&K Precision Corporation, located at Yorba Linda, California, USA, to confirm the first-order, or linear relation of the inductance with the cable length. Turning now to FIG. 9, the measured relation between inductance and the distance-to-short at various locations of a CAT5 cable is shown. The measurement was repeated once to determine the repeatability. The physical orientation of the cable was not changed during the second measurement, leaving the measurement error as the only variable. A least square fit was then performed on the data measured. The least square fit is shown with a straight line in FIG. 9. One can see from FIG. 9 that the dependence is, indeed, close to being linear.
The unit inductance of the CAT5 cable was found to be approximately 264 nH/ft.

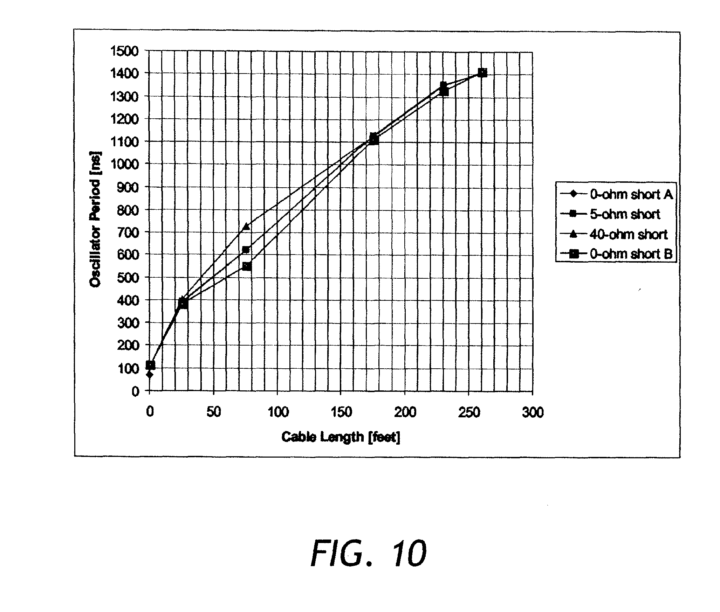

Referring now to FIG. 10, a measured relationship between the oscillation period and the distance to short of a CAT5 cable is shown. The oscillation period was measured using a Model 3034B Oscilloscope manufactured by Tektronix Corporation, Richardson, Texas, USA. Four measurements were conducted in the following sequence:

First measurement: a 0Ω short was inserted at various lengths of the unshielded CAT5 cable, and the corresponding oscillation periods were measured;

Second measurement: a 5Ω resistive fault was inserted at various lengths of the unshielded CAT5 cable, and the corresponding oscillation periods were measured;

Third measurement: a 40Ω resistive fault was inserted at various lengths of the unshielded CAT5 cable, and the corresponding oscillation periods were measured;

Fourth measurement: a 0Ω short was inserted again at various lengths of the unshielded CAT5 cable, to demonstrate repeatability of the technique, and the corresponding oscillation periods were measured.

Each set of measurement was completed before the next measurement was performed. As seen in FIG. 10, the oscillation period is not overly sensitive to the resistance of the fault, and the measurement-to-measurement variations are minimal.

The method of the present invention does not involve a direct measurement of the inductance of a cable. Cable inductance measurement requires a more complex circuit, periodic calibrations, and a higher component count, which can be cost prohibitive. Instead, the method described comprises counting pulses produced by a simple oscillator circuit having coupled thereto either the cable under test or a reference inductor.

An important feature of the present invention is a circuit for suppressing a nonreactive component of the cable's electrical characteristics to the measured oscillation period. This method can be practiced using a very simple equipment having far less components than a standard inductance meter for measuring both the phase and magnitude responses of a device-under-test (DUT) at various frequencies. The device of the present invention can be used to measure a cable length to any low-resistance fault, however caused.

## Claims

1. A device for measuring a length $l_{fault}$ between a measurement point of a test cable having an inductance, and a low-resistance fault point of the test cable, wherein the device comprises:

an oscillator having an input and an output, for producing, at its output, electrical oscillations **characterized by** an oscillation period depending upon the inductance of the test cable coupled to the input of the oscillator at the measurement point, wherein said inductance is representative of $l_{fault}$; and

a processing device for determining $l_{fault}$ by measuring a test value based on said oscillation period and comparing the measured test value to a reference value.

2. A device of claim 1,

wherein the cable has a capacitance and a resistance, wherein said resistance depends upon a resistance of the low-resistance fault;

wherein the oscillation period of the oscillator is dependent upon the cable capacitance and upon the cable resistance;

wherein the dependence of the oscillation period upon the inductance, the capacitance, and the resistance is **characterized by** a sensitivity of said oscillation period to a relative variation of the inductance, the capacitance, and the resistance, respectively; and

wherein the oscillator is constructed such that the sensitivity of the oscillation period thereof to a relative variation of the inductance of the cable is greater than the sensitivity of the oscillation period thereof to a relative variation of the resistance or the capacitance of the cable.

3. A device of claim 2, wherein the oscillator comprises a pair of transistors in an inductive oscillator circuit.

4. A device of claim 3, wherein each of the transistors has a base, an emitter, and a collector, and wherein the oscillator further comprises a pair of resistors each having a first and a second terminal,

wherein the emitters of the transistors are coupled to each other;

wherein the base of one transistor is coupled to the collector of the other transistor, and vice versa;

wherein the collector of one transistor is coupled to the first terminal of one resistor, and the collector of the other transistor is coupled to the first terminal of the other resistor;

wherein the second terminals of the resistors are coupled to each other; and

wherein the bases of the transistors form the input of the oscillator.

5. A device of claim 1, wherein $l_{fault}$ is either proportional to the test value, or is a polynomial function of the test value.

6. A device of claim 1, further comprising:

a comparator having an input and an output, wherein the input of the comparator is coupled to the output of the oscillator, for producing, at the output of the comparator, a digital signal **characterized by** a frequency substantially equal to an oscillation frequency of the oscillator; and

a pre-scaler having an input and an output, wherein the input of the pre-scaler is coupled to the output of the comparator, for producing, at the output of the pre-scaler, a digital signal **characterized by** a frequency that is a pre-defined fraction of the frequency of the digital signal at the output of the comparator;

wherein the processing device is a microprocessor for determining $l_{fault}$ by measuring the frequency of the digital signal at the output of the pre-scaler and comparing said frequency to a reference frequency,

wherein the output of the pre-scaler is coupled to the microprocessor, and

wherein the device further comprises a display coupled to the microprocessor, for displaying the determined value of $l_{fault}$.

7. A device of claim 1, further comprising a background inductor coupled to the input of the oscillator.

8. A device of claim 1, further comprising a switch for switching the input of the oscillator between the cable at the first measurement point and a reference inductor usable for determining the reference value by measuring a value based on the oscillation period of the oscillator when input thereof is coupled by the switch to the reference inductor.

9. A device of claim 8, wherein the reference inductor is a reference cable having: a measurement point for coupling to the switch; and an electrical short at a pre-determined cable length from the measurement point.

10. A method for measuring a length $l_{fault}$ between a measurement point of a test cable having an inductance, and a low-resistance fault point of said test cable, wherein the method comprises:

(a) coupling the test cable to an input of an oscillator circuit at the measurement point,

wherein the oscillator circuit is **characterized by** an oscillation period; and

wherein, upon said coupling, said oscillation period is dependent upon the inductance of the test cable;

(b) measuring a test value based on the oscillation period of the oscillator; and

(c) determining $I_{fault}$ by comparing the measured test value to a reference value.

**11.** A method of claim 10,

wherein in step (a), the test cable has a capacitance and a resistance, wherein said resistance depends upon a resistance of the low-resistance fault;

wherein upon coupling, the oscillation period of the oscillator depends upon the capacitance and on the resistance of the test cable;

wherein the dependence of the oscillation period on the inductance, the capacitance, and the resistance is **characterized by** sensitivity of said oscillation period to a relative variation of the inductance, the capacitance, and the resistance, respectively; and

wherein upon coupling, the sensitivity of the oscillation period of the oscillator to a relative variation of the inductance of the cable is greater than the sensitivity of said oscillation period to a relative variation of the resistance or the capacitance of the cable.

**12.** A method of claim 10, wherein the step (c) further comprises measuring the reference value by

(d) coupling a reference inductor to the input of the oscillator; and

(e) measuring the reference value, wherein said reference value is based on the oscillation period of the oscillator.

**13.** A method of claim 12, wherein the reference inductor is a reference cable having: a measurement point for coupling to the input of the oscillator; and an electrical short at a pre-determined cable length from said measurement point.

**14.** A method of claim 12, wherein the reference inductor is a sample with a pre-determined inductance.

**15.** A method of claim 14, wherein in step (c), said length between the measurement point and the fault point, $I_{fault}$, is determined according to the following equation:

$$l_{fault} = \frac{T_{cable}}{T_{reference}} \cdot \frac{\eta_{reference}}{\gamma_{cable}}$$

wherein: $T_{cable}$ and $T_{reference}$ are the oscillation periods of the oscillator having coupled to the input thereof the test cable and the reference inductor, respectively; $\eta_{reference}$ is an inductance value of the reference inductor; and $\gamma_{cable}$ is a per-unit-length inductance of the test cable.

100

$l_{fault}$

113

112

114

$L_{ref}$

115

103

Inductive
Oscillator
Circuit

102

110

107

Comparator and
Pre-Scaler

104

105

Microprocessor

106

Display (Length
to Fault)

108

*FIG. 1*

FIG. 2

FIG. 3

FIG. 4

FIG. 5

602

604

Ch1 200mV Ch2 2.00V M 1.00μs

*FIG. 6*

EP 2 120 058 A2

704

706

Ch2 2.00V  Ch3 2.00V  M 4.00μs

*FIG. 7*

FIG. 8

FIG. 9

EP 2 120 058 A2

FIG. 10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 61053213 B
- US 7076374 B
- US 6646454 B